# EUROPEAN PATENT SPECIFICATION

(11) **EP 2 383 773 B1**
(45) Date of publication and mention of the grant of the patent: **08.05.2013**
(21) Application number: 11163617.1
(22) Date of filing: 23.04.2011
(51) Int. Cl.: H01L 21/306, C25F 3/16, B24B 37/04

(54) **Method of electrochemical-mechanical polishing of silicon carbide wafers**
Verfahren zum elektrochemisch-mechanischen Polieren von Siliciumcarbid-Wafern
Procédé de polissage mécanique électrochimique de tranches à carbure de silicium

(30) Priority: 27.04.2010 PL 39107610
(43) Date of publication of application: 02.11.2011
(73) Proprietor: Instytut Technologii Materialów Elektronicznych, 01-919 Warszawa (PL)
(72) Inventor: Sakowska, Halina, 85-500, Józefoslaw (PL); Gala, Maciej, 01-926, Warszawa (PL); Hofman, Wladyslaw, 03-379, Warszawa (PL)
(74) Representative: Sielewiesiuk, Jakub

(56) References cited:
- CANHUA LI ET AL: "Electro-chemical mechanical polishing of silicon carbide", JOURNAL OF ELECTRONIC MATERIALS, vol. 33, no. 5, 1 May 2004 (2004-05-01), pages 481-486, XP55025187, ISSN: 0361-5235, DOI: 10.1007/s11664-004-0207-6
- MAZUR K ET AL: "Influence of SiC Surface Preparation on Homoepitaxial Growth; X-ray Reflectometric Studies", ACTA PHYSICA POLONICA A INSTITUTE OF PHYSICS OF THE JAGELLONIAN UNIVERSITY POLAND, vol. 117, no. 2, February 2010 (2010-02), pages 272-276, XP002674384, ISSN: 0587-4246

## Description

The subject of the invention is a method of electrochemical-mechanical polishing of silicon carbide wafers, used in electronics, especially for manufacturing diodes and transistors based on SiC in high power and high frequency systems.

Substrate wafers of SiC should be characterized by the perfect quality of surface that is required for depositing epitaxial layers. Wafer surface quality depends on the crystallographic quality of SiC crystal and to high extent on the preparation method, i.e. treatment of the surface.

In order to obtain a good quality of epitaxial layer, the substrate wafer surface must be free of defects and as smooth as possible.

The method of obtaining properly smooth surface of SiC known from X.Chen et al., J.of Material Science of Technology, 22, 5, 681-684 (2006) consists in multi-stage treatment with diamond grain using suspensions of reducing average grain. However, diamond grain, while smoothing the surface, simultaneously causes the generation of near surface damage layer. Polishing with hard diamond grain that removes SiC layer, also leads to propagation of micro-fractures, and consequently the presence of the near surface damage layer is inevitable. Surface obtained in this way has many scratches visible under the microscope.

From the publications: Ling Shou et al., J.of Electrochemical Society, 144, 6, 161-163 (1997); Peter Cuo and Ian Currier, Materials Science Forum, 527-529 (2006) 1099-1102 and patent specification of PCT WO 2005/099388A2, the CMP method of mechanical and chemical polishing is known that combines the process of chemical etching, i.e. oxidizing the surface, with the process of mechanical polishing. This process employs an oxidizing agent, such as hydrogen peroxide H₂O₂ and colloidal silica SiO₂.

Due to a high chemical resistance of SiC to chemical agents, in comparison with the reactivity of the silicon Si for example, the rate of removing of the SiC layer is of the order of 10 nm/h compared to 50 nm/h in case of polishing of silicon. CMP is time consuming and does not provide the expected results.

In order to increase the effectiveness of polishing, modified ACMP process is used, known from the publication W.J. Everson et al., Materials Science Forum, 527-529, (2006) 1091-1094, which process consists in increasing the rate of oxidation of the SiC layer at the same time balancing the mechanical rate of removing obtained SiO₂ by applying alternative abrasive grain with proper graining and selection of oxidizing agent concentration.

From the US patent specification No. 7060602 B2 a method is known that combines soaking of SiC wafers in the oxidizing atmosphere in order to oxidize SiC surface to SiO₂ and then polishing thus prepared surface with colloidal silica until obtaining the surface smoothness required for epitaxy.

From the US patent specification No. 4946547 techniques based on ion or plasma etching are known. They are competitive to the methods employing polishing from the point of view of layer removal rate, but do not provide the surface smoothness required for epitaxy.

From the publication by Keita Yagi et al., Japanese J.Applied Physic, 47, 1, 104-107 (2008), the method of smoothing surfaces is known based on the application of oxidizing properties of OH˙ radicals generated by metal atoms, such as Fe, contained in the polishing plate is known.

In the work described in the publication by Canhua Li et al., Electronics Materials, 33, 5, 481-486 (2004), a two-stage ECMP process was used. Within the 1st stage, anode oxidizing of SiC surface to SiO₂ within about 30 seconds was performed using pure hydrogen peroxide H₂O₂ at a current density of 1 mA/cm2, while in the 2nd stage, chemical and mechanical polishing to remove SiO₂ layer using water suspension of colloidal silica within 30 min was performed. Both stages were being repeated until obtaining the polished surface without scratches visible under the microscope. The SiC wafers were glued to aluminium polishing holder using adhesive wax. Additionally, between the SiC wafer and the holder, a layer of metallic indium was applied that provided electrical contact. In this way, a free of scratches SiC surface, having the smoothness of R≤0,200nm, free of defective layer was obtained. However, this method requires simultaneous meeting of a few conditions. Gluing the wafer to the holder requires a high accuracy, in order to provide good fixing of the wafer, but also a good electrical contact. Any less precise positioning of the indium layer causes losses of current flowing through the wafer, and in consequence imprecise measurement of current intensity of the current flowing through the wafer. The gluing wax, necessary for effective fixing of the SiC wafer, must at the same time serve as an insulator on the vertical walls of the samples holder, disabling any current flow between the holder and the electrolyte on the polishing plate, which omits the SiC wafer, and moreover it should not limit the indium contact surface. Meeting these conditions limits the application of this method to single trials.

The purpose of the invention was to develop simple, less time consuming, clean and repeatable technology that enables obtaining a high quality SiC wafer surface, free from defects and of high smoothness.

The method according to invention consists in that in the 1st stage, a silicon carbide SiC wafer is adhesively fixed on a replaceable insert of a conductive material in a socket of a cassette that does not conduct current and has at least one socket, said cassette being permanently fixed to a polishing holder made of a conductive material, said holder being positioned in the head of an electrochemical-mechanical polishing device and the polishing plate of the polishing device is being lined with a polishing pad for chemical polishing, resistant to aggressive chemical agents, such as acids or alkalis, after which the holder is connected with the anode and the polishing pad moistened with an electrolyte layer that enables current flow is connected to the cathode, connecting the electrode outputs with a direct current feeder and electric current is passed through thus prepared system.

In the 2nd stage, after washing and rinsing, the wafer is placed in the cassette socket again, onto an insert replaced to a non-conductive one, and the wafer is subjected to polishing with colloidal silica, after which the thus obtained the wafer is washed, rinsed with water and dried.

Preferably, three wafers are fixed in three sockets of said cassette.

Preferably, a cassette of non-conductive polycarbonate is used.

Preferably, a polishing holder made of aluminium is used.

In the 1st stage, the insert made of aluminium is preferably placed in the cassette.

In the 2nd stage, the insert of plastic is preferably placed in the cassette, thus enabling the wafer to rotate freely in the cassette socket, and at the same time protecting the non-polished side of the wafer against the contact with polishing holder material.

In the 1st stage, during the passage of the current, the holder is preferably rotated and the polishing plate is left fixed.

In the 2nd stage, the holder and polishing plate are preferably rotated in opposite directions.

In order to provide stable and safe fixing of the SiC wafer in the cassette socket during polishing, the depth of the cassette socket is preferably adjusted to the thickness of SiC wafer and the thickness of replaceable insert, such that 1/3 of the wafer thickness protrudes over the cassette and 2/3 remains inside the socket.

During the 1st stage, the insert of conductive material, pressed from one side by the polished SiC wafer and on the other side by the holder, "adapts" to the surfaces adjacent to it, providing efficient passage of electric current through the SiC wafer.

The diameter of the cassette socket, wherein the SiC wafer is placed together with the insert, is slightly larger than the diameter of the wafer, it provides a free rotation of the wafer about its own axis during polishing and a free inserting and removing of the wafer from the cassette socket before and after the polishing.

The method according to the invention provides a good passage of current during the 1st stage of polishing and moreover, due to fixing of the wafers in the device without the need to apply additional adhesive agents that provide current passage, and directly contacting with them, it provides clean process technology without the need to wash the wafers in organic solvents after both stages of polishing.

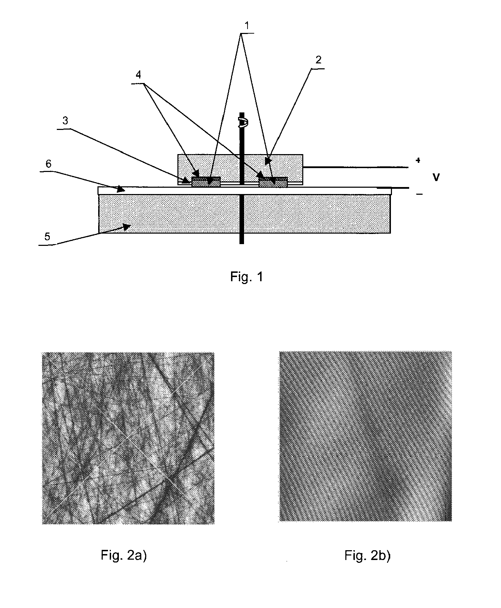

The examples described below illustrate the method according to invention in particular embodiments based on an exemplary system for polishing, presented schematically in fig. 1. To illustrate the obtained results, an exemplary image from an atomic forces microscope AFM of SiC surface before and after polishing is presented in fig. 2a) and b), respectively.

### Example 1

Three wafers 1 of 4H SiC having the orientation (0001), and an off-angle of 4° with respect to the direction [0001], having the diameter φ=1" and thickness (1.00±0.05) mm were preliminarily prepared by polishing of diamond suspensions with decreasing graining 15 µm, 9 µm, 6 µm, 1 µm, 0.25 µm and 0.1 µm and by cleaning in an ultrasonic wash.

A polishing holder 2 of aluminium was positioned in the head of an electrochemical-mechanical polishing device, not shown in the drawing. The cassette 3 of non-conductive polycarbonate, with three sockets-cavities, having the diameter minimally larger than the diameter of the wafers 1, was glued to the holder 2. In the sockets of the cassette 3, replaceable aluminium inserts 4 were placed, having the diameter equal to the diameter of the wafers 1 and having the thickness of 0.100 mm, after which the wafers 1 were adhesively fixed such that 1/3 of the thickness of each of them protruded over the cassette 3, and 2/3 of said thickness remained inside the socket. The polishing plate 5 was lined with a polishing pad 6 for chemical polishing, resistant to aggressive chemical agents, especially to alkalis. The polishing pad 6 was moistened with a freshly prepared 10% water solution of KNO₃ Then the holder 2 was connected with the anode and the cathode was connected to the polishing pad 6, connecting both outputs of the electrodes with a direct current feeder and current was passed for 30 seconds. Density of the electric current passing through the wafers 1 was 1 mA/cm². During the passage of the current, the polishing plate 5 remained fixed and the head of the device together with the holder 2 with wafers 1 was rotated at 150 rpm with pressure during polishing of 20 psi.

Then the wafers 1 were removed from the cassette 3, washed in an ultrasound wash with a water solution of sodium pyrophosphate, rinsed with water and put again into the socket of the cassette 3, substituting the aluminium insert 4 with a polyurethane insert 4. The polishing pad 6 was also washed.

The thus prepared wafers 1 were subjected to the 2nd stage of polishing using the water suspension of colloidal silica of medium grain of 50 nm and pH of 9.6. The holder 2 and polishing plate 5 were rotated in directions opposite to each other. The polishing time was 30 min, plate 5 rotations of 150 rpm with pressure on the wafer 1 of 5 psi, the head with wafers 1 rotations of 120 rpm. Once the polishing has been completed, the wafers 1 were washed in an ultrasonic wash with a sodium pyrophosphate solution, rinsed with water and dried.

Both stages of polishing were repeated 6 times.

Polished wafers 1 were washed in the mixture of ammonium hydroxide NH₃•H₂O and hydrogen peroxide H₂O₂, then in hydrofluoric acid HF and additionally in the mixture of hydrochloric acid HCI and hydrogen peroxide H₂O₂.

The analysis of wafer 1 surfaces smoothness was performed using the atomic forces microscope AFM. The roughness parameter, after preliminary polishing with diamond suspension of graining 0.1 µm, was Ra=0.24 nm, after two stages of ECMP polishing was Ra=0.20 nm.

### Example 2

Three wafers 1 of 6H SiC, having the orientation (0001), and an off-angle of 8° with respect to the direction [0001], having the diameter φ=1" and thickness (1.00±0.05) mm were preliminarily prepared like in example 1. The polishing process was performed in two stages, like in example 1.

## Claims

1. A method of electrochemical-mechanical polishing of silicon carbide, SiC, wafers by anode oxidizing of the external layer of the wafers on their silicon-terminated side to SiO2 and subsequent polishing with colloidal silica, **characterized in that** in the 1st stage, a silicon carbide SiC wafer (1) is adhesively fixed on a replaceable insert (4) of a conductive material in a socket of a cassette (3) that does not conduct current and has at least one socket, said cassette (3) being permanently fixed to a polishing holder (2) made of a conductive material, said holder (2) being positioned in the head of an electrochemical-mechanical polishing device and the polishing plate (5) of the polishing device is being lined with a polishing pad (6) for chemical polishing, resistant to aggressive chemical agents, after which the holder is connected with the anode and the polishing pad (6) moistened with an electrolyte layer that enables current flow is connected to the cathode, connecting the electrode outputs with a direct current feeder and electric current is passed through thus prepared system, an then in the 2nd stage, after washing and rinsing, the wafer (1) is placed in the cassette (3) socket again, onto an insert (4) replaced to a non-conductive one, and the wafer is subjected to polishing with colloidal silica, after which the thus obtained the wafer (1) is washed, rinsed with water and dried.

2. The method according to claim 1, **characterized in that** three wafers (1) are fixed in three sockets of said cassette (3).

3. The method according to claim 1, **characterized in that** a cassette (3) of non-conductive polycarbonate is used.

4. The method according to claim 1, **characterized in that** a polishing holder (2) made of aluminium is used.

5. The method according to claim 1, **characterized in that** in the 1st stage, the insert (4) made of aluminium is placed in the cassette (3).

6. The method according to claim 1, **characterized in that** in the 2nd stage, the insert (4) of plastic is placed in the cassette (3).

7. The method according to claim 1, **characterized in that** in the in the 1st stage, during the passage of current, the holder (2) is rotated and the polishing plate (5) is left fixed.

8. The method according to claim 1, **characterized in that** in the 2nd stage, the holder (2) and polishing plate (5) are rotated in opposite directions.

9. The method according to claim 1, **characterized in that** the depth of the cassette (3) socket is preferably adjusted to the thickness of the SiC wafer (1) and the thickness of the replaceable insert (4), such that 1/3 of the wafer thickness protrudes over the cassette (3) and 2/3 remains inside the socket.

## Patentansprüche

1. Verfahren zum elektrochemisch-mechanischen Polieren von Platinen aus Siliziumcarbid SiC durch anodische Oxidierung der Außenschicht der Platinen auf deren Siliziumseite zur SiO₂-Gestalt, und anschließendes Polieren mit Kolloidsiliziumdioxid, **gekennzeichnet dadurch dass** im 1. Schritt an die erste Polierhalterung (2) aus leitfähigem in der im Kopf des Geräts zum elektrochemisch-mechanischen Polieren angeordneten Material mit dauerhaft fixierter nichtleitfähiger Kassette (3) mit mindestens einer Aufnahme, auf einer austauschbaren Unterlage (4) aus leitfähigem Material adhäsiv die Platine aus Siliziumcarbid SiC fixiert wird, und die Polierscheibe (5) des Poliergeräts mit Stoff (6) zum chemischen Polieren ausgelegt wird, der gegen die Wirkung von aggressiven Chemiemitteln beständig ist, wonach die Halterung (2) mit einer Anode verbunden wird, und an den mit einem Elektrolytfilm benetzten Polierstoff (6) eine Katode angelegt wird, wodurch die beiden Ausgänge der Elektroden mit einer Gleichstromeinspeisung verbunden werden, worauf durch eine so entstandene Schaltung elektrischer Strom geleitet wird, und anschließend im 2. Schritt die Platine (1) nach Reinigung und Spülung erneut in der Aufnahme der Kassette (3) auf der genannten nichtleitfähigen Unterlage (4) fixiert und einem Polieren mittels Kolloidsiliziumdioxid unterzogen wird, wonach eine derart polierte Platine (1) mit Wasser gereinigt und getrocknet wird.

2. Verfahren nach Anspruch 1, **dadurch gekennzeichnet, dass** in den drei Aufnahmen der Kassette (3) drei Platinen fixiert werden (1).

3. Verfahren nach Anspruch 1, **dadurch gekennzeichnet, dass** eine aus nichtleitfähigem Polycarbonat hergestellte Kassette (3) eingesetzt wird.

4. Verfahren nach Anspruch 1, **dadurch gekennzeichnet, dass** eine Polierhalterung (2) aus Aluminium eingesetzt wird.

5. Verfahren nach Anspruch 1, **dadurch gekennzeichnet, dass** im 1. Schritt in der Kassette (3) eine Unterlage (4) aus Aluminium angeordnet wird.

6. Verfahren nach Anspruch 1, **dadurch gekennzeichnet, dass** im 2. Schritt in der Kassette (3) eine Unterlage aus Kunststoff angeordnet wird.

7. Verfahren nach Anspruch 1, **dadurch gekennzeichnet, dass** im 1. Schritt während des Stromflusses die Halterung (2) rotiert, und die Polierscheibe (5) feststehend bleibt.

8. Verfahren nach Anspruch 1, **dadurch gekennzeichnet, dass** im 2. Schritt die Halterung (2) und die Polierscheibe (5) in zwei zueinander entgegengesetzten Richtungen rotieren.

9. Verfahren nach Anspruch 1, **dadurch gekennzeichnet, dass** die Tiefe der Aufnahme der Kassette (3) so an die Stärke der SiC Platine (1) und an die Stärke der austauschbaren Unterlage (4) angepasst wird, dass 1/3 der Plattenstärke über die Kassette (3) herausragt, und 2/3 innerhalb der Haltung bleibt.

## Revendications

1. Procédé de polissage mécano-électrochimique des plaquettes de carbure de silicium SiC par oxydation anodique de la couche externe des plaquettes sur leur côté de silicium au SiO₂ et leur polissage ultérieur avec de la silice colloïdale, **caractérisé en ce que** dans la première étape sur la poignée de polissage (2) de matériau conducteur, située dans la tête de l'appareil de polissage mécano-électrochimique, avec une cassette (3) non conductrice montée en permanence avec au moins une fente, dans laquelle sur un patin échangeable (4) de matériau conducteur, on fixe adhésivement une plaquette (1) de carbure de silicium SiC, et un disque de polissage (5) de l'appareil de polissage est étalé à l'aide d'une étoffe (6) pour le polissage chimique, résistante aux agents chimiques agressifs, ensuite la poignée (2) est reliée à l'anode, et à l'étoffe de polissage (6) mouillée avec une couche d'électrolyte, on applique une cathode, en connectant les sorites d'électrode à une chargeuse de courant continu, et on passe le courant électrique par le circuit ainsi formé, ensuite dans la deuxième étape la plaquette (1), après lavage et rinçage, est placé à nouveau dans la fente de la cassette (3) sur le patin échangé pour celui non conducteur (4) et elle est soumise au polissage avec de la silice colloïdale, puis la plaquette ainsi polie (1) est lavée, rincée à l'eau et séchée.

2. Procédé selon la revendication 1, **caractérisé en ce que** dans trois fentes de la cassette (3) on fixe trois plaquettes (1).

3. Procédé selon la revendication 1, **caractérisé en ce que** on utilise une cassette (3) de polycarbonate non conducteur.

4. Procédé selon la revendication 1, **caractérisé en ce que** on utilise une poignée de polissage (2) en aluminium.

5. Procédé selon la revendication 1, **caractérisé en ce que** dans la première étape dans la cassette (3) on place un patin (4) en aluminium.

6. Procédé selon la revendication 1, **caractérisé en ce que** dans la deuxième étape dans la cassette (3) on place un patin (4) en plastique.

7. Procédé selon la revendication 1, **caractérisé en ce que** dans la première étape au cours du passage du courant, on fait tourner la poignée (2), et on laisse le disque de polissage (5) immobile.

8. Procédé selon la revendication 1, **caractérisé en ce que** dans la deuxième étape on fait tourner la poignée (2) et le disque de polissage (5) dans des directions opposées l'une à l'autre.

9. Procédé selon la revendication 1, **caractérisé en ce que** le profondeur de fente de la cassette (3) est choisi, relativement à l'épaisseur de la plaquette SiC (1) et l'épaisseur du patin échangeable (4) de sorte que 1/3 de l'épaisseur de la plaquette dépasse la cassette (3), et 2/3 reste à l'intérieur de la fente.
